(19) Europäisches Patentamt / European Patent Office / Office européen des brevets

(11) **EP 4 415 212 B1**

(12) **EUROPEAN PATENT SPECIFICATION**

(45) Date of publication and mention
of the grant of the patent:
**24.09.2025 Bulletin 2025/39**

(21) Application number: **24155827.9**

(22) Date of filing: **05.02.2024**

(51) International Patent Classification (IPC):
*H02J 7/00* ^(2006.01)    *B25F 5/00* ^(2006.01)

(52) Cooperative Patent Classification (CPC):
**H02J 7/0025; B25F 5/00; H02J 7/0063**

(54) **POWER SUPPLY CONTROL CIRCUITS, POWER TOOLS, AND POWER TOOL SYSTEMS**

STROMVERSORGUNGSSTEUERSCHALTUNGEN, ELEKTROWERKZEUGE UND ELEKTROWERKZEUGSYSTEME

CIRCUITS DE COMMANDE D'ALIMENTATION ÉLECTRIQUE, OUTILS ÉLECTRIQUES ET SYSTÈMES D'OUTILS ÉLECTRIQUES

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: 10.02.2023   CN 202310105895
19.05.2023   CN 202310567254
19.05.2023   CN 202321231600 U

(43) Date of publication of application:
**14.08.2024 Bulletin 2024/33**

(73) Proprietor: **Greenworks (Jiangsu) Co., Ltd.**
**Changzhou, Jiangsu 213023 (CN)**

(72) Inventors:
• **WEI, Zefeng**
**Changzhou, 213023 (CN)**
• **LI, Biao**
**Changzhou, 213023 (CN)**

(74) Representative: **Bergenstråhle & Partners AB**
**P.O. Box 17704**
**118 93 Stockholm (SE)**

(56) References cited:
EP-A1- 3 288 147      TW-B- I 790 903
US-A1- 2014 265 604   US-A1- 2023 238 817
US-B1- 6 268 711

**Description**

TECHNICAL FIELD

The present application relates to power supply control circuits, power tools, and power tool systems, and belongs to the technical field of control circuits.

BACKGROUND

Currently, power tools using dual or multiple battery packs on the market are equipped with power supply control circuits to switch between different battery packs. A relay may be added at the output end of the power supply control circuit for isolation. When the power tool is turned off, the connection between the external socket and the internal energy storage capacitor may be effectively cut off, thereby avoiding the risk of the external socket being electrified.

US 6,268,711 discloses a battery manager that provides the ability to switch multiple batteries or other forms of power sources to power external devices individually, in series, and/or in parallel. The device is typically electronic based and consists of voltage level detecting circuits for comparing each power source to a reference voltage, FET control logic for controlling the switching matrix, and a switching matrix which accomplishes the required configuration of power sources to provide an output power source.

US2023/238817 discloses a power tool including a first connecting port, a second connecting port, a motor module, a first switching member, a second switching member, and a control device. The first switching member is connected between the motor module and the first connecting port. The second switching member is connected between the motor module and the second connecting port. The control device is connected to the first switching member and the second switching member. A control method of the power tool includes switching on the first switching member and the second switching member when the control device determines that both the first connecting port and the second connecting port are respectively connected to a battery and a difference between voltages inputted to the first connecting port and the second connecting port is smaller than a predetermined voltage difference, allowing two batteries to supply power to the motor module at the same time.

SUMMARY

Embodiments of the present application provide a power supply control circuit, a power tool, and a power tool system. In exemplary embodiments, a power supply control circuit, a power tool, and a power tool system may automatically switch between different battery packs for power supply.

The present application provides a power supply control circuit.

The power supply control circuit includes: a main control chip module connected to at least two battery packs; at least two control circuits connected in parallel with each other, wherein an input end of the control circuit is connected to the main control chip module, and an output end of the control circuit is provided on a power supply path from the battery pack to a power tool to control a connection and disconnection of the battery packs; and a voltage detection circuit, wherein an input end of the voltage detection circuit is connected to the power supply path from the battery pack to the power tool, and an output end of the voltage detection circuit is connected to the main control chip module. The main control chip module is configured to control the connection and disconnection of the battery packs through the control circuit based on feedback from the voltage detection circuit, and control a currently connected battery pack to be disconnected and select another battery pack to be connected when the voltage detection circuit detects that a voltage of the currently connected battery pack is less than a predetermined value.

The control circuit includes an activation circuit, a trigger circuit, and a switch circuit sequentially connected in series, and the activation circuit is connected to the main control chip module such that the main control chip module controls the activation circuit to be turned on to activate the trigger circuit to drive the switch circuit to control a connection state of the battery pack.

The activation circuit includes two resistors and one transistor, a base of the transistor is connected to the main control chip module through a first resistor of the two resistors, an emitter of the transistor is grounded, and a second resistor of the two resistors is connected between the emitter and the base of the transistor in series.

In exemplary embodiments of the present application, the trigger circuit is a flip-flop, and the flip-flop is configured to be activated by the activation circuit and generate a self-oscillation signal to drive the switch circuit to control the connection state of the battery pack.

In exemplary embodiments of the present application, the flip-flop includes two capacitors, one resistor, and three NAND gates, a first NAND gate and a second NAND gate of the three NAND gates are connected in parallel, the resistor is connected to a third NAND gate of the three NAND gates in parallel, the third NAND gate includes a first pin and a second pin, the second pin of the third NAND gate is connected to the first NAND gate and the second NAND gate, the two capacitors are connected to the third NAND gate and grounded.

In exemplary embodiments of the present application, an oscillation frequency of the trigger is:

$$f = \cfrac{1}{R3 \cdot C1 \cdot \ln \cfrac{VT^+(15 - VT^-)}{VT^-(15 - VT^+)}},$$

wherein VT+ and VT- are a positive threshold voltage and a negative threshold voltage of the trigger circuit respectively, R3 is a resistance value of the resistor connected to the third NAND gate in parallel, and C1 is a capacitance value of the capacitor connected to the first pin and grounded.

In exemplary embodiments of the present application, the switch circuit includes a gate circuit and a switching transistor connected on the power supply path from the battery pack to the power tool in series, and the connection state of the battery pack is controlled by turning-on and turning-off of the switching transistor.

In exemplary embodiments of the present application, the switch circuit includes a gate circuit and two switching transistors connected on the power supply path from the battery pack to the power tool in series, the two switching transistors are connected in parallel, a first switching transistor of the two switching transistors is connected to the battery pack in a forward direction, and a second switching transistor of the two switching transistors is connected to the battery pack in a reverse direction.

In exemplary embodiments of the present application, the power supply control circuit further includes a startup circuit connected to the battery pack and the main control chip module. The startup circuit supplies power to the main control chip module and a drive circuit module after the startup circuit receives a triggering signal from the outside and a driving signal of the main control chip module.

In exemplary embodiments of the present application, the power supply control circuit further includes a filtering circuit. The filtering circuit includes a capacitor and a resistor connected in parallel, and a positive electrode of the capacitor is connected to a main circuit of the battery pack.

The present application also provides a power tool, which is provided with a power supply control circuit as described above, and wherein the power supply control circuit further comprises a drive circuit module connected to the main control chip module and the battery pack respectively, where the drive circuit module is also connected to a motor to drive the motor after the battery pack is connected.

The present application also provides a power tool system comprising at least two battery packs and a power tool as defined above

The exemplary embodiments of the present application have one or more beneficial effects described as below. In the present application, at least two control circuits connected in parallel are provided, the input end of the control circuit is connected to the main control chip module, and the output end of the control circuit is configured on the power supply path from the battery packs to the power tool. Therefore, the main control chip module may control the connection and disconnection of the battery pack through the control circuit based on the feedback of the voltage detection circuit. When the voltage detection circuit detects that the voltage of the currently connected battery pack is less than a predetermined value, the main control chip module controls the disconnection of the currently connected battery pack and selects another battery pack to connect. Compared with the traditional technology, the present application may use the main control chip module to automatically switch the power supply from different battery packs, which is conducive to the miniaturization design of the PCB and reduces the overall cost. In a power supply control circuit according to exemplary embodiments of the present application, an energy storage capacitor, a discharge resistor, and a switching element form a main loop, the discharge resistor is connected to the energy storage capacitor in parallel, and the switching element is set between the negative electrode of the energy storage capacitor and ground. Therefore, the front-stage drive circuit may be used to control the switching element to be turned on or off. When the switching element is turned on, the battery pack charges the energy storage capacitor. When the switching element is turned off, the discharge resistor and the energy storage capacitor form a loop in which the discharge resistor discharges the energy storage capacitor, so that there is no residual voltage on the energy storage capacitor, so that there is no risk of the external plug socket being electrified. In addition, the occupied area on the PCB and the cost are reduced.

BRIEF DESCRIPTION OF DRAWINGS

FIG. 1 is a circuit schematic diagram of a power supply control circuit according to exemplary embodiments of the present application.
FIG. 2 is a functional block diagram of a power supply control circuit according to exemplary embodiments of the present application.
FIG. 3 is a schematic diagram of the circuit structure of a startup circuit in FIG. 2.
FIG. 4 is a schematic circuit structure diagram of a first activation circuit in FIG. 2.
FIG. 5 is a schematic circuit structure diagram of a first trigger circuit in FIG. 2.
FIG. 6 is a schematic circuit structure diagram of a first switch circuit in FIG. 2.
FIG. 7 is a schematic circuit structure diagram of a second activation circuit in FIG. 2.
FIG. 8 is a schematic circuit structure diagram of a second trigger circuit in FIG. 2.
FIG. 9 is a schematic circuit structure diagram of a second switch circuit in FIG. 2.
FIG. 10 is a schematic circuit structure diagram of a drive circuit module in FIG. 2.
FIG. 11 is a schematic circuit structure diagram of a voltage detection circuit and a filtering circuit in FIG. 2.
FIG. 12 is a schematic circuit structure diagram of a power supply control circuit according to exemplary embodiments of the present application.

DESCRIPTION OF EMBODIMENTS

In order to make the purpose, technical solutions and advantages of the present application clearer, the present application will be described in detail below with reference to the accompanying drawings and specific embodiments.

Here, it should be noted that, in order to avoid obscuring the present application with unnecessary details, only the structures and/or processing steps closely related to the solution of the present application are shown in the drawings, and other details that are less relevant to the present application are omitted.

Additionally, it should be noted that the terms "comprise", "include", "have", and any other variation thereof are intended to be non-exclusive, such that a process, method, article, or device that includes a list of elements includes not only those elements, but also other elements not expressly listed or that are inherent to the process, method, article, or device.

For high-voltage products of 80V or above, after unplugging the battery pack, there will be a residual voltage of 80V at both ends of the socket due to the discharge of the energy storage capacitor. In traditional technology, in order to effectively cut off the connection between the external socket and the internal energy storage capacitor and avoid the risk of the external socket carrying charges. Relays may be used on the PCB for isolation. However, relays may occupy a relatively large area and may be costly, and may not be suitable for widespread use. In view of this, the present application proposes a new type of power supply control circuit, which may solve the problem that the energy storage capacitor is discharged after the battery pack is unplugged so that the residual voltage exists at both ends of the socket, which in turn causes the risk of the socket being electrified.

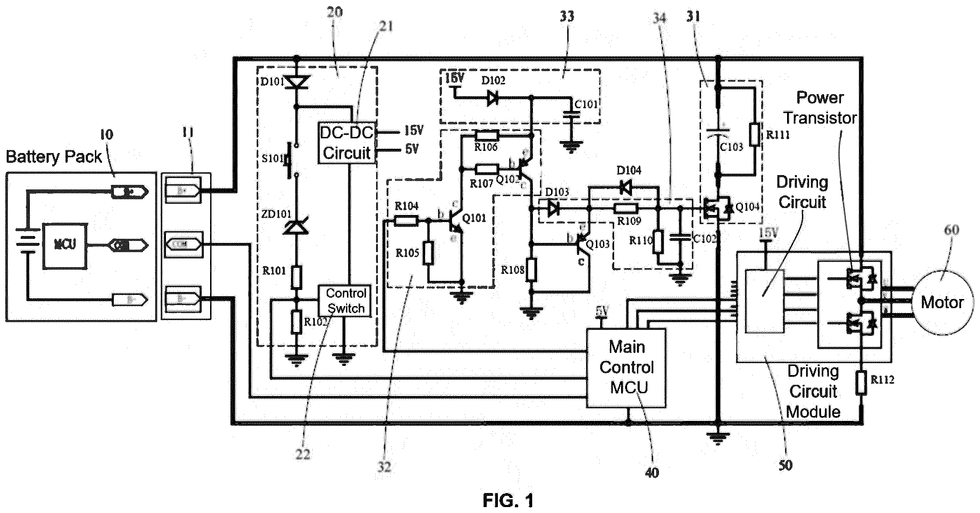

As shown in FIG. 1, in exemplary embodiments of the present application, the power supply control circuit includes: a main control chip module 40 connected to an external battery pack 10, a drive circuit module 50 connected to the main control chip module 40 and the battery pack 10 respectively, a startup circuit 20 connected to the battery pack 10, a front-stage drive circuit, and a main loop 31 connected to the front-stage drive circuit and the battery pack 10.

In exemplary embodiments of the present application, the power supply control circuit is fixed to and electrically connected to the external battery pack 10 through a socket 11 in a plug-in way. In order to facilitate the description and more intuitively reflect the power transmission process of the battery pack 10, the following description will directly describe the connection relationship between the battery pack 10 in a plugged-in state and various components of the power supply control circuit.

As shown in FIG. 1, the battery pack 10 is a removable external battery pack, which is connected to an internal main circuit of a high-voltage driver and configured to power the entire power supply control circuit. The main control chip module 40 is connected to the battery pack 10, the startup circuit 20, the front-stage drive circuit, and the drive circuit module 50, respectively, so that the main control chip module 40 can control the startup and shutdown of each circuit.

In exemplary embodiments of the present application, the main control chip module 40 is a main control MCU (e.g., microcontroller unit) and is powered by the startup circuit 20. The main control MCU is internally integrated with a startup sequence logic, a shutdown sequence logic, a drive signal logic, and other pre-programmed functional programs, so as to enable the corresponding startup control, shutdown control, and drive control.

As shown in FIG. 1, the startup circuit 20 is connected to the battery pack 10 and configured to provide power after a startup switch S101 is activated. In exemplary embodiments of the present application, the startup circuit 20 includes: a first diode D101 connected to the positive electrode of the battery pack 10, a startup switch S101 connected to the first diode D101, a power-supply output circuit 21 connected to the first diode D101, a voltage stabilization diode ZD101 connected to the startup switch S101, a voltage dividing circuit connected to the voltage stabilization diode ZD101, and a control switch 22 located between the voltage dividing circuit and the power-supply output circuit 21. When the startup switch S101 is closed, the battery pack 10 supplies power to the voltage dividing circuit, the control switch 22 is closed, and the power-supply output circuit 21 can output power.

As shown in FIG. 1, one end of the startup switch S101 is connected to the first diode D101 for receiving the voltage from the positive electrode of the battery pack 10, and the other end of the startup switch S101 is connected to the voltage stabilization diode ZD101 for stably transmitting the voltage from the positive electrode of the battery pack 10 to the voltage dividing circuit.

As shown in FIG. 1, the voltage dividing circuit includes a first voltage dividing resistor R101 and a second voltage dividing resistor R102 connected in series. The other end of the first voltage dividing resistor R101 is connected to the voltage stabilization diode ZD101, and the other end of the second voltage dividing resistor R102 is grounded. The control switch 22 is connected at the connection between the first voltage dividing resistor R101 and the second voltage dividing resistor R102.

The power-supply output circuit 21 is a DC-DC circuit that can output a voltage of 15V or 5V. The main control chip module 40 is connected to the power-supply output circuit 21 and is configured to receive the voltage output by the power-supply output circuit 21. In exemplary embodiments, the power-supply output circuit 21 outputs a voltage of 5V to the main control chip module 40 so that the main control chip module 40 can start normally.

As shown in FIG. 1, one end of the drive circuit module 50 is connected to the main control chip module 40, and the other end of the drive circuit module 50 is connected to the motor 60 for driving the motor 60 to start when the main control chip module 40 outputs a startup signal and driving the motor 60 to stop when the chip module 40 outputs a shutdown signal. The drive circuit module 50 is also connected to the power-supply output circuit 21 to receive the voltage of 15V output by the power-supply output circuit 21.

In exemplary embodiments of the present application, the drive circuit module 50 includes a drive circuit and a power transistor. The drive circuit is connected to the main control chip module 40, and the power transistor is connected to the drive circuit and the motor 60 respectively. Therefore, when working, the main control chip module 40 sends a control instruction to the drive circuit such that the drive circuit controls the corresponding power transistor to be turned on or off according to the received control instruction and then controls the motor 60 to operate normally or stop running.

As shown in FIG. 1, the main loop 31 includes an energy storage capacitor C103, a discharge resistor R111, and a switching element. For example, the switching element is a field effect transistor Q104. The front-stage drive circuit is connected to the field effect transistor Q104 and is configured to control the working status of the main loop 31.

In exemplary embodiments of the present application, the positive electrode of the energy storage capacitor C103 is connected to the positive electrode of the battery pack 10, the negative electrode of the energy storage capacitor C103 is connected to the negative electrode of the battery pack 10 and grounded. The discharge resistor R111 is connected in parallel with the energy storage capacitor C103, and the field effect transistor Q104 is connected between the negative electrode of the energy storage capacitor C103 and the ground. The front-stage drive circuit is configured to control the field effect transistor Q104 to turn on or off. When the field effect transistor Q104 is turned on, the battery pack 10 can charge the energy storage capacitor C103. When the field effect transistor Q104 is turned off, the discharge resistor R111 and the energy storage capacitor C103 form a loop and the discharge resistor R111 discharges the energy storage capacitor C103, so that there is no residual voltage on the energy storage capacitor C103 and there will be no risk of the socket 11 being electrified.

As shown in FIG. 1, the front-stage drive circuit includes: a level conversion circuit 32 connected to the main control chip module 40, a power-supply rectification and filtering circuit 33 connected to the level conversion circuit 32, a gate driving circuit 34 connected to the level conversion circuit 32, and a shutdown circuit connected to the level conversion circuit 32 and the gate driving circuit 34. The power-supply rectification and filtering circuit 33 is configured to supply power to the level conversion circuit 32. The gate driving circuit 34 is also connected to the field effect transistor Q104 for turning on or off the field effect transistor Q104 under the control of the main control chip module 40 and the level conversion circuit 32.

As shown in FIG. 1, the power-supply rectification and filtering circuit 33 is also connected to the power-supply output circuit 21, so that when the startup switch S101 is closed, the power-supply output circuit 21 can output a voltage of 15V to the power-supply rectification and filtering circuit 33, causing the power-supply rectification and filtering circuit 33 to supply power to the level conversion circuit 32.

In exemplary embodiments of the present application, the power-supply rectification and filtering circuit 33 includes a second diode D102 and a first capacitor C101 connected in series. The other end of the second diode D102 is connected to the power-supply output circuit 21, and the other end of the first capacitor C101 is grounded. In exemplary embodiments, the second diode D102 is a rectification diode, and the first capacitor C101 is a filtering capacitor.

As shown in FIG. 1, the field effect transistor Q104 is an N-channel MOSFET. The gate driving circuit 34 includes a third diode D103, a ninth resistor R109, a tenth resistor R110, and a gate capacitor C102. The input end of the third diode D103 is connected to the level conversion circuit 32, the output end of the third diode D103 is connected to the input end of the ninth resistor R109, the output end of the ninth resistor R109 is connected to the gate of the field effect transistor Q104, the tenth resistor R110 and the gate capacitor C102 are connected in parallel and are connected between the ninth resistor R109 and the gate of the field effect transistor Q104, and the other end of the gate capacitor C102 is grounded.

As shown in FIG. 1, the level conversion circuit 32 includes a first switching transistor Q101 connected to the main control chip module 40, and a second switching transistor Q102 connected to the first switching transistor Q101. The input end of the third diode D103 is connected to the output end of the second switching transistor Q102. Therefore, when the first switching transistor Q101 and the second switching transistor Q102 are turned on, the battery pack 10 charges the gate capacitor C102 and drives the field effect transistor Q104 to turn on after the gate level of the field effect transistor Q104 reaches a turn-on voltage, so that the positive and negative electrodes of the battery pack 10 form a loop, and then the battery pack 10 charges the energy storage capacitor C103.

As shown in FIG. 1, in exemplary embodiments of the present application, the first switching transistor Q101 is an NPN-type transistor, and the second switching transistor Q102 is a PNP-type transistor. The base (b electrode) of the first switching transistor Q101 is connected to the main control chip module 40 through a fourth resistor R104, the collector (c electrode) of the first switching transistor Q101 is connected to the base (b electrode) of the second switching transistor Q102 through a seventh resistor R107, the emitter (e electrode) of the first switching transistor Q101 is grounded, the emitter (e electrode) of the second switching transistor Q102 is connected to the output end of the second diode D102, and the collector (c electrode) of the second switching transistor Q102 is connected to the input end of the third diode D103.

As shown in FIG. 1, the level conversion circuit 32 includes a fifth resistor R105 connected between the base (b electrode) and the emitter (e electrode) of the first switching transistor Q101 and a sixth resistor R106 connected between the collector (c electrode) of the first switching transistor Q101 and the emitter (e electrode) of the second switching transistor Q102.

As shown in FIG. 1, the shutdown circuit includes a third switching transistor Q103 connected to the second switching transistor Q102, a fourth diode D104 connected in parallel with the ninth resistor R109, and an eighth resistor R108 through which the second switching transistor Q102 and the third switching transistor Q102 are grounded. The fourth diode D104 is configured to transmit the gate voltage of the field effect transistor Q104 to the third switching transistor Q103 when the first switching transistor Q101 and the second switching transistor Q102 are turned off, so that the third switching transistor Q103 is turned on by connecting to the ground through the eighth resistor R108 to form a turn-off discharge circuit to turn off the field effect transistor Q104.

As shown in FIG. 1, the third switching transistor Q103 is a PNP transistor, and the base (b electrode) of the third switching transistor Q103 is connected to the collector (c electrode) of the second switching transistor Q102 and is grounded through the eighth resistor R108. The emitter (e electrode) of the third switching transistor Q103 is connected to the output end of the fourth diode D104, and the collector (c electrode) of the third switching transistor Q103 is grounded.

As shown in FIG. 1, in exemplary embodiments of the present application, the first switching transistor Q101 is an NPN transistor, and the second switching transistor Q102 and the third switching transistor Q103 are both PNP transistors. Therefore, the working logic of the first switching transistor Q101, the second switching transistor Q102, and the third switching transistor Q103 are described below. When the main control chip module 40 sends a high level (5V) to the base (b electrode) of the first switching transistor Q101, the first switching transistor Q101 is turned on if Ube is greater than 0.7V (that is, Ub-Ue>0.7V) in the case where the emitter (e electrode) is forward biased and the collector (c electrode) is reverse biased, i.e., Uc>Ub>Ue. After the first switching transistor Q101 is turned on, the base (b electrode) of the second switching transistor Q102 will be grounded through the seventh resistor R107. At this time, the second switching transistor Q102 is turned on if Ueb is greater than 0.7V (that is, Ue-Ub>0.7V) in the case where the emitter (e electrode) of the second switching transistor Q102 is forward biased and the collector (c electrode) of the second switching transistor Q102 is reverse biased, i.e., Uc<Ub<Ue.

On the contrary, when the main control chip module 40 sends a low level (0V) to the base (b electrode) of the first switching transistor Q101, the first switching transistor Q101 is turned off since Ube is not greater than 0.7V because both the emitter (e electrode) and the collector (c electrode) of the first switching transistor Q101 are reverse biased. When the first switching transistor Q101 is turned off, the base (b electrode) of the second switching transistor Q102 is connected to a high level of 15V through the seventh resistor R107 and the sixth resistor R106. At this time, the second switching transistor Q102 is turned off since Ueb is not greater than 0.7V because both the emitter (e electrode) and the collector (c electrode) of the second switching transistor Q102 are reverse biased. Similarly, the working principle of the third switching transistor Q103 and the second switching transistor Q102 are the same. To put it simply, the first switching transistor Q101 is turned on at a high level and turned off at a low level, and the second switching transistor Q102 and the third switching transistor Q103 are turned on at a low level and turned off at a high level.

As shown in FIG. 1, the working principle of the power supply control circuit of the present application will be described below. When the battery pack 10 is plugged into the socket 11 and the startup switch S101 is pressed, the positive electrode of the battery pack 10 provides a bias voltage to the control switch 22 through the first diode D101, the startup switch S101, the voltage stabilization diode ZD101, a first voltage dividing resistor R101, and a second voltage dividing resistor R102, causing the control switch 22 to conduct and supply power to the DC-DC circuit 21. The DC-DC circuit 21 generates output voltages of 15V and 5V, respectively, which are used to supply power to the drive circuit module 50 and the main control MCU 40, etc., to make each circuit module enter the working mode.

As shown in FIG. 1, when starting up, the working logic includes the following steps. In the first step: the main control MCU 40 sends a high level to the first switching transistor Q101, then the first switching transistor Q101 is turned on and grounded, then the second switch transistor Q102 is triggered and turned on; at this time, the voltage of 15V, after rectified by the rectification diode D102 and filtered by the filter capacitor C101, goes through the emitter and the collector of the second switching transistor Q102, and then goes through the third diode D103 and the ninth resistor R109 to charge the gate capacitor C102; when the gate level of the field effect transistor Q104 reaches the turn-on voltage VGS(th), the field effect transistor Q104 can be driven to turn on; at this time, the negative electrode of the energy storage capacitor C103 can be connected to the negative electrode of the battery pack 10 and grounded, and the positive and negative electrodes of the battery pack 10 form a loop; at this time, the battery pack 10 can charge the energy storage capacitor C103. In the second step: after a certain period of time, the main control MCU 40 sends a control signal to the drive circuit module 50 to turn on the drive circuit module 50 and allow the motor 60 to operate normally; at this time, the energy storage capacitor C103 has enough energy to continuously drive the motor 60 to operate.

As shown in FIG. 1, when shutting down, the working logic includes the following steps. In the first step: the main control MCU 40 first turns off the drive circuit module 50 to stop the motor 60. In the second step: the main control MCU 40 sends a low level to the first switching transistor Q101, causing the first switching transistor Q101 to turn off; when the first switching transistor Q101 turns off, the second switching transistor Q102 is cut off due to reverse bias; at this time, the gate voltage of the field effect transistor Q104 goes to the emitter (e electrode) of the third switching transistor Q103 through the fourth diode D104; due to the reverse bias of the third diode D103, the base (b electrode) of the third switching transistor Q103 is grounded through the eighth resistor R108, forming a turn-off discharge loop, which pulls the gate voltage of the field effect transistor Q104 down to the ground, making the gate level of the field effect transistor Q104 lower than the turn-on voltage VGS(th) such that the field effect transistor Q104 is turned off. At this time, if the battery pack 10 is unplugged, the discharge resistor R111 and the energy storage capacitor C103 form a loop, and the discharge resistor R111 discharges the energy storage capacitor C103, so that there is no residual voltage on the energy storage capacitor C103, and the problem of the socket 11 being electrified no longer exists.

As shown in FIG. 1, there are two main situations regarding unplugging the battery pack 10. In the first situation where the battery pack 10 is plugged-in with the startup switch S101 not pressed and then the battery pack 10 is unplugged, the DC-DC circuit 21 and the main control MCU 40 will not be activated, so the field effect transistor Q104 will not be turned on. Since the field effect transistor Q104 isolates the negative electrode of the energy storage capacitor C103 from the GND end, the positive and negative electrodes of the battery pack 10 will not form a loop. As a result, the energy storage capacitor C103 will not be charged and electrified. Therefore, there is no risk of the socket 11 being electrified. In the second situation where the battery pack 10 is unplugged after working and the field effect transistor Q104 is turned off, the discharge resistor R111 and the energy storage capacitor C103 form a loop and the discharge resistor R111 discharges the energy storage capacitor C103, so that there will be no residual voltage on the energy storage capacitor C103, and there will be no risk of socket 11 being electrified.

As shown in FIG. 1, in exemplary embodiments of the present application, a field effect transistor Q104 is added for isolation between the negative electrode of the energy storage capacitor C103 and the GND end to assess whether there is a risk of the socket 11 being electrified. Only in the situation where the field effect transistor Q104 is turned on, the battery pack 10 can charge the energy storage capacitor C103. When the field effect transistor Q104 is turned off, the discharge resistor R111 will discharge the energy storage capacitor C103, so that the socket 11 is not electrified.

As shown in FIG. 1, in exemplary embodiments of the present application, in the power supply control circuit, the energy storage capacitor C103, the discharge resistor R111, and the field effect transistor Q104 form the main loop 31, the discharge resistor R111 is configured to be connected to the energy storage capacitor C103 in parallel, and the field effect transistor Q104 is provided between the negative electrode of the energy storage capacitor C103 and the ground. Therefore, the front-stage drive circuit can be configured to control the field effect transistor Q104 to turn on or off, and only when the field effect transistor Q104 is turned on, the battery pack 10 can charge the energy storage capacitor C103. After the battery pack 10 is unplugged, the field effect transistor Q104 is turned off, the discharge resistor R111 and the energy storage capacitor C103 form a loop where the discharge resistor R111 discharges the energy storage capacitor C103, so that there is no residual voltage on capacitor C103. Therefore, there is no risk of socket 11 being electrified. Compared with the traditional technology, the occupied area on the PCB may be reduced and the cost may be reduced.

Exemplary embodiments of the present application also propose a power tool that uses the aforementioned power supply control circuit. In exemplary embodiments, the power tool may solve the problem that after the battery pack is unplugged, the energy storage capacitor is discharged, causing residual voltage to exist at both ends of the socket, which in turn brings a risk of the socket being electrified.

Exemplary embodiments of the present application also propose a power tool system. The power tool system includes a power tool and a battery pack. The power tool includes a main body, and a motor is provided in the main body. The battery pack is configured to supply power to the power tool to drive the motor to operate. It should be noted that at least two of the battery packs are provided and may provide power to the power tool respectively.

In exemplary embodiments of the present application, the power tool is provided with a power supply control circuit, and the power supply control circuit can switch different battery packs to respectively supply power to the power tool. In exemplary embodiments of the present application, the battery pack may include a first battery pack, a second battery pack, a third battery pack, or a fourth battery pack, etc. In the present application, the first battery pack and the second battery pack are taken as examples for description.

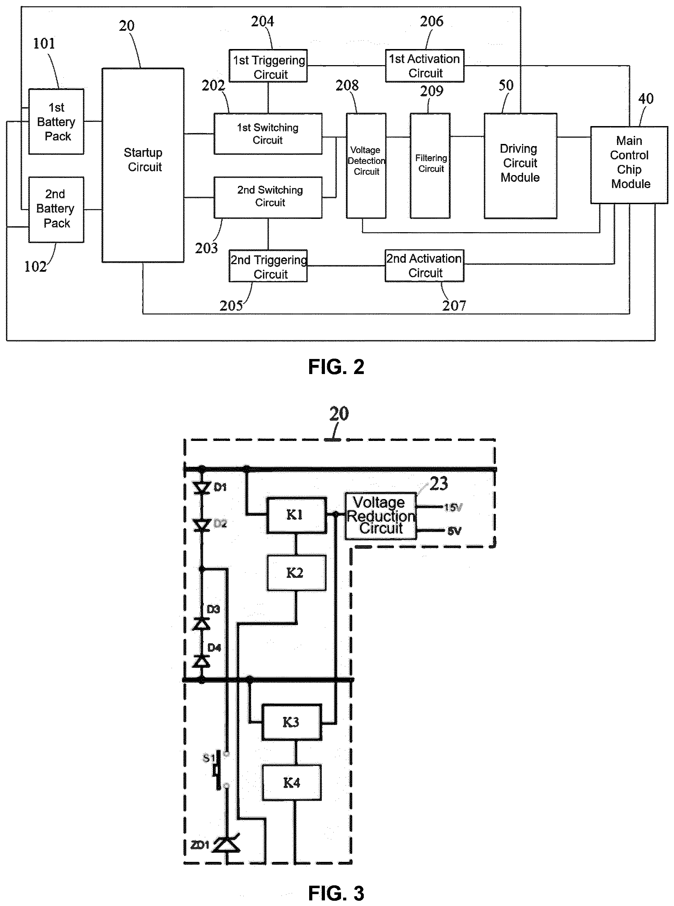

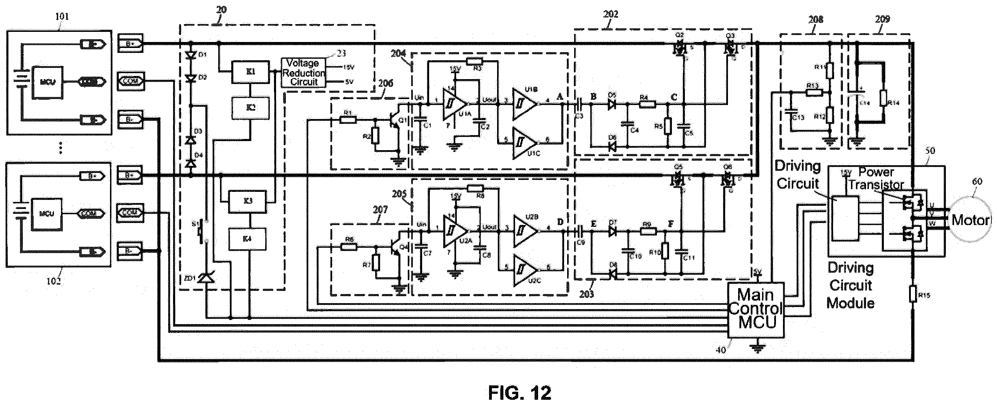

As shown in FIG. 2 and FIG. 12, in exemplary embodiments of the present application, the power supply control circuit includes a drive circuit module 50, a main control chip module 40, a control circuit, a voltage detection circuit 208, and a startup circuit 20. In exemplary embodiments, the drive circuit module 50 is connected to the battery pack so that the battery pack supplies power to the drive circuit module 50. The drive circuit module 50 is also connected to the motor 60 to drive the motor 60 after the battery pack is connected. The main control chip module 40 is connected to the battery pack and the drive circuit module 50 respectively. The startup circuit 20 is connected to the battery pack and the main control chip module 40 respectively. When the startup circuit 20 receives a trigger signal from outside and a driving signal from the main control chip module 40, power is supplied to the main control chip module 40 and the drive circuit module 50.

As shown in FIG. 2 and FIG. 12, it should be noted that in exemplary embodiments of the present application, when the number of battery packs is two, the battery packs may include a first battery pack 101 and a second battery pack 102. In exemplary embodiments, two adjacent battery packs are connected in parallel. For example, the first battery pack 101 and the second battery pack 102 are connected in parallel.

As shown in FIG. 3 and FIG. 12, the first battery pack 101 is provided with first electrical connection ends B+ and B-, the second battery pack 102 is provided with second electrical connection ends B+ and B-, and the main control chip module 40 is provided with a first communication end COM integrated with the first electrical connection ends B+ and B- and a second communication end COM integrated with the second electrical connection ends B+ and B-. In exemplary embodiments, the first battery pack 101 is connected to the first electrical connection ends B+ and B-, and the first communication end COM, and the second battery pack 102 is connected to the second electrical connection ends B+ and B- and the second communication end COM.

As shown in FIG. 3 and FIG. 12, the startup circuit 20 is configured to connect the first electrical connection end B+ and the second electrical connection end B+. In exemplary embodiments of the present application, the startup circuit 20 includes a diode D1, a diode D2, a diode D3, a diode D4, a startup switch S1, a voltage stabilization diode ZD1, a switching transistor K1, a switching transistor K2, a switching transistor K3, a switching transistor K4, and a voltage reduction circuit 23. In exemplary embodiments, the diode D1, the diode D2, the diode D3, and the diode D4 are connected in series in sequence and connected between the first electrical connection end B+ and the second electrical connection end B+. For example, the diode D2 is connected to the positive electrode of the first battery pack 101, the diode D3 is connected to the positive electrode of the second battery pack 102, the conduction directions of the diode D1 and the diode D2 are the same, the conduction directions of the diode D3 and the diode D4 are the same, and the conduction directions of the diode D2 and the diode D3 are opposite. In exemplary embodiments, one end of the startup switch S1 is connected between the output ends of the diode D2 and the diode D3, the other end of the startup switch S1 is connected to the negative electrode of the voltage stabilization diode ZD1, and the positive electrode of the voltage stabilization diode ZD1 is connected to the main control chip module 40.

As shown in FIG. 3 and FIG. 12, the switching transistor K1 and the switching transistor K2 form a first control switch, the switching transistor K3 and the switching transistor K4 form a second control switch, and the voltage reduction circuit 23 is connected to the first control switch and the second control switch respectively. The switching transistor K1 and the switching transistor K2 are connected in series, the switching transistor K1 is connected to the first electrical connection end B+, and the switching transistor K2 is connected to the main control chip module 40. The switching transistor K3 and the switching transistor K4 are connected in series, the switching transistor K3 is connected to the second electrical connection end B+, and the switching transistor K4 is connected to the main control chip module 40. The voltage reduction circuit 23 is connected to the switching transistor K1 and the switching transistor K3 respectively.

As shown in FIG. 3 and FIG. 12, when the startup switch S1 is closed, the positive electrode of the first battery pack 101 provides a bias voltage through the diode D1, the diode D2, the startup switch S1, and the voltage stabilization diode ZD1, causing the switching transistor K2 and the switching transistor K1 to be turned on, so that power is supplied to the voltage reduction circuit 23. Then the voltage reduction circuit 23 generates outputs of 15V and 5V for supplying power to the drive circuit module 50, the main control chip module 40, etc., respectively, so that each circuit module enters the working mode. The positive electrode of the second battery pack 102 provides a bias voltage through the diode D4, the diode D3, the startup switch S1, and the voltage stabilization diode ZD1, causing the switching transistor K4 and the switching transistor K3 to be turned on, so that power is supplied to the voltage reduction circuit 23. Then the voltage reduction circuit 23 generates outputs of 15V and 5V for supplying power to the drive circuit module 50, the main control chip module 40, etc., respectively, so that each circuit module enters the working mode.

As shown in FIG. 2 and FIG. 12, there are at least two control circuits connected in parallel. The input end of the control circuit is connected to the main control chip module, and the output end of the control circuit is provided on a power supply path from the battery pack to the power tool to control the connection and disconnection of the battery pack.

The control circuit includes a switch circuit, a trigger circuit, and an activation circuit. The switch circuit includes a gate circuit connected to the trigger circuit and a switching transistor connected in series on the power supply path from the battery pack to the power tool. The switch circuit is connected to the battery pack through the switching transistor. The trigger circuit is connected between the gate circuit and the activation circuit. That is, the trigger circuit is arranged between the switch circuit and the activation circuit. The activation circuit is connected to the main control chip module. That is, the switch circuit, the trigger circuit, and the activation circuit are sequentially connected in series, so that the main control chip module controls the activation circuit to turn on, thereby activating the trigger circuit so as to drive the switch circuit to control the connecting state of the battery pack, that is, to drive the gate circuit to operate, causing the switching transistor to turn on, and then the corresponding first battery pack or second battery pack supplies power. It should be noted that the trigger circuit is a flip-flop. For example, the trigger circuit is a Schmitt trigger. The flip-flop is activated by the activation circuit and generates a self-oscillation signal to drive the switch circuit to control the connection state of the battery pack.

As shown in FIG. 2 and FIG. 12, when there are two battery packs, two groups of control circuits are provided. Correspondingly, two groups of switch circuits, trigger circuits, and activation circuits are also provided.

That is, the battery packs include a first battery pack 101 and a second battery pack 102. The first battery pack 101 and the second battery pack 102 are connected in parallel. A first switch circuit 202, a first trigger circuit 204, and a first activation circuit 206 are connected in series and provided between the main control chip module 40 and the first battery pack 101. A second switch circuit 203, a second trigger circuit 205, and a second activation circuit 207 are connected in series and provided between the main control chip module 40 and the second battery pack 102.

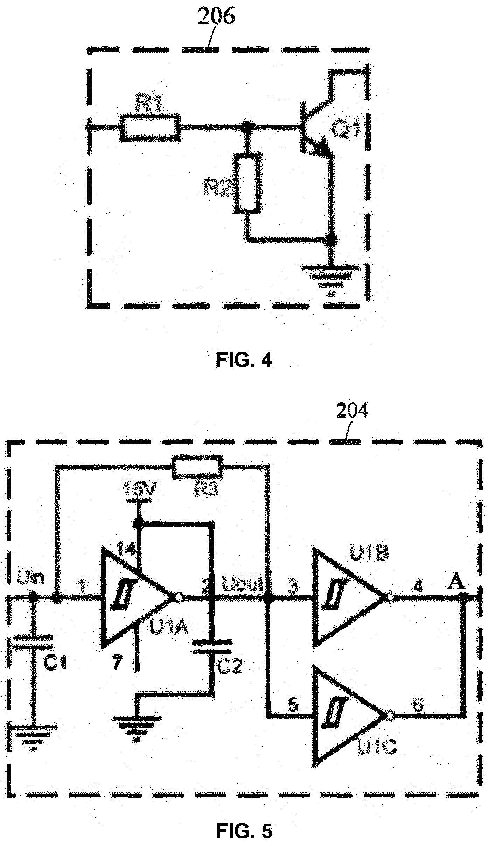

As shown in FIG. 4 to FIG. 6, in exemplary embodiments of the present application, the first switch circuit 202 includes a switching transistor Q2, a switching transistor Q3, a capacitor C3, a capacitor C4, a resistor R4, a resistor R5, a capacitor C5, a diode D5, and a diode D6. In exemplary embodiments, the switching transistor Q2 and the switching transistor Q3 are both connected in series with the first battery pack 101 and connected to the main circuit connected to the drive circuit module 50. The switching transistor Q2 and the switching transistor Q3 are connected in parallel, and one of the switching transistor Q2 and the switching transistor Q3 is connected to the first battery pack 101 in a forward direction, and the other of the switching transistor Q2 and the switching transistor Q3 is connected to the first battery pack 101 in a backward direction. In exemplary embodiments, the switching transistor Q2 is separately connected in series on the power supply path from the battery pack to the power tool, and then the connection state of the first battery pack 101 and the second battery pack 102 may be controlled by turning on and off the switching transistor Q2.

As shown in FIG. 4 to FIG. 6, the capacitor C3, the capacitor C4, the resistor R4, the resistor R5, the capacitor C5, the diode D5, and the diode D6 form the first gate circuit. The capacitor C3, the diode D5, and the resistor R4 are sequentially connected in series and connected to the switching transistor Q2 and the switching transistor Q3. One end of the capacitor C3 is connected to the trigger circuit and the other end of the capacitor C3 is connected to the diode D5. The negative electrode of the diode D6 is connected between the capacitor C3 and the diode D5. The diode D6 and the diode D5 are connected in parallel and their conduction directions are opposite. The positive electrode of the diode D6 is connected between the switching transistor Q2 and the switching transistor Q3. The capacitor C4 is connected to the negative electrode of the diode D5 and the positive electrode of the diode D6, respectively. One end of the capacitor C4 is connected to the output end of the diode D5, and the other end of the capacitor C4 is connected to the input end of diode D6. One end of the resistor R5 is connected to the positive electrode of the diode D6, and the other end of the resistor R5 is connected between the resistor R4 and the switching transistor Q2. That is, one end of the resistor R5 is connected to the output end of the resistor R4, and the other end of the resistor R5 is connected to the input end of the diode D6. One end of the capacitor C5 is connected to the positive electrode of the diode D6, and the other end of the capacitor C5 is connected between the resistor R4 and the switching transistor Q2. The capacitor C5 is connected to the resistor R5 in parallel.

As shown in FIG. 4 to FIG. 6, in order to drive the first switch circuit 202 to work normally, a trigger circuit must be added at the front end of the first gate circuit to generate a self-excited oscillation signal (that is, a periodically changing rectangular wave) to drive the gate circuit to work, and further control the turning-on and turning-off of the switching transistor Q2 and the switching transistor Q3.

As shown in FIG. 4 to FIG. 6, the first trigger circuit 204 includes a capacitor C1, a capacitor C2, a resistor R3, a NAND gate U1A, a NAND gate U1B, and a NAND gate U1C. In exemplary embodiments, the NAND gate U1B and the NAND gate U1C are connected in parallel and then connected to the capacitor C3. That is, a third pin of the NAND gate U1B is connected to the capacitor C3. The NAND gate U1A has a first pin Uin and a second pin Uout, and the second pin Uout is connected to the third pin of NAND gate U1B. The resistor R3 is connected to the NAND gate U1A in parallel and the second pin Uout of the NAND gate U1A is connected to the NAND gate U1B. The capacitor C1 is connected to the first pin Uin and grounded, and the capacitor C2 is connected to a pin 14 of the NAND gate U1A and grounded.

The oscillation frequency of the first trigger circuit 204 is:

$$f = \frac{1}{R3 \cdot C1 \cdot \ln\dfrac{VT^+(15 - VT^-)}{VT^-(15 - VT^+)}},$$

where $VT^+$ and $VT^-$ are the positive threshold voltage and the negative threshold voltage of the first trigger circuit 204 respectively, R3 is the resistance value of the resistor R3, and C1 is the capacitance value of the capacitor C1. In the first trigger circuit 204, when the voltage of the first pin Uin is increasing, when $Uin<VT^+$, the output of the second pin Uout is 15V, and when $Uin>VT^+$, the output of the second pin Uout is 0V; when the voltage of the first pin Uin is decreasing, when $Uin>VT^-$, the output of the second pin Uout is 0V, and when $Uin<VT^-$, the output of the second pin Uout is 15V.

As shown in FIG. 4 to FIG. 6, to work, the first trigger circuit 204 needs the activation from an activation circuit of the previous stage to work. The first activation circuit 206 is controlled by the main control chip module 40 to be turned on or off. The first activation circuit 206 includes a resistor R1, a resistor R2, and a transistor Q1. The collector of the transistor Q1 is connected to the first pin Uin of NAND gate U1A. The two ends of the resistor R2 are connected to the base and emitter of transistor Q1 respectively and the emitter of the transistor Q1 is grounded. The resistor R1 is connected to the base of the transistor Q1 and the main control chip module 40 respectively.

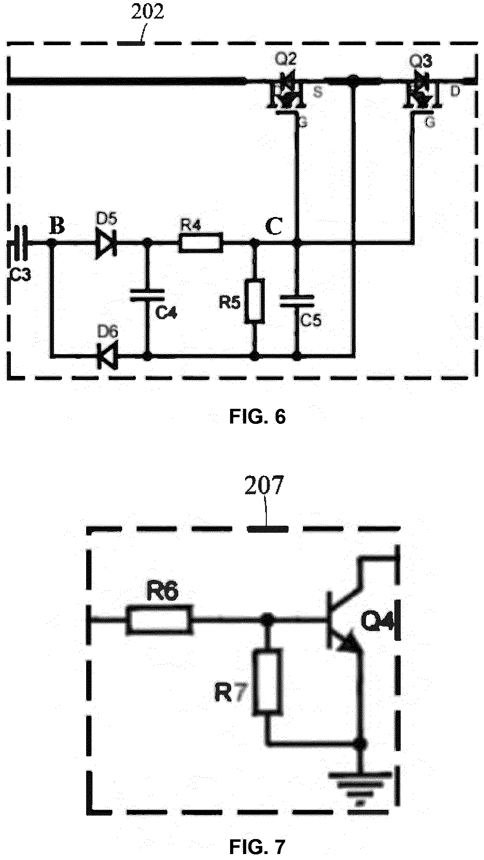

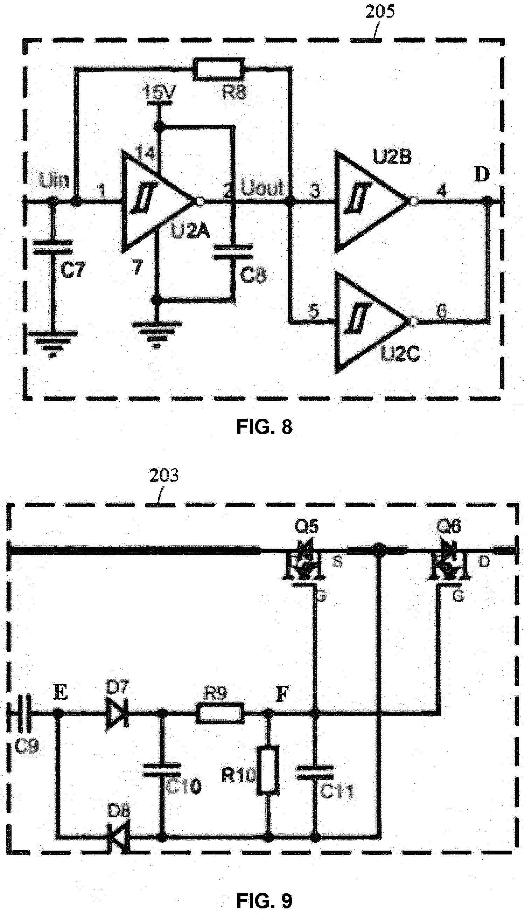

As shown in FIG. 7 to FIG. 9, the second switch circuit 203 includes a switching transistor Q5, a switching transistor Q6, a capacitor C9, a capacitor C10, a resistor R9, a resistor R10, a capacitor C11, a diode D7, and a diode D8. In exemplary embodiments, the switching transistors Q5 and the switching transistor Q6 are connected to the second battery pack 102 in series and connected to the second electrical connection end B+. The switching transistor Q5 and the switching transistor Q6 are connected in parallel and the conduction directions of the switching transistor Q5 and the switching transistor Q6 are opposite.

As shown in FIG. 7 to FIG. 9, the capacitor C9, the capacitor C10, the resistor R9, the resistor R10, the capacitor C11, the diode D7, and the diode D8 form the second gate circuit. The capacitor C9, the diode D7, and the resistor R9 are sequentially connected in series and connected to the switching transistor Q5 and the switching transistor Q6. The negative electrode of the diode D8 is connected between the capacitor C9 and the diode D7, and the positive electrode of the diode D8 is connected between the switching transistor Q5 and the switching transistor Q6. The capacitor C10 is connected to the negative electrode of the diode D7 and the positive electrode of the diode D8 respectively. One end of the resistor R10 is connected to the positive electrode of the diode D8, and the other end of the resistor R10 is connected between the resistor R9 and the switching transistor Q5. One end of the capacitor C11 is connected to the positive electrode of the diode D8, and the other end of the capacitor C11 is connected between the resistor R9 and the switching transistor Q5.

As shown in FIG. 7 to FIG. 9, the second trigger circuit 205 includes a capacitor C7, a capacitor C8, a resistor R8, a NAND gate U2A, a NAND gate U2B, and a NAND gate U2C. In exemplary embodiments, the NAND gate U2B and the NAND gate U2C are connected in parallel and then connected to the capacitor C9. That is, a third pin of the NAND gate U2B is connected to the capacitor C9. The NAND gate U2A has a first pin Uin and a second pin Uout. The second pin Uout of the NAND gate U2A is connected to the third pin of the NAND gate U2B. The resistor R8 is connected in parallel with the NAND gate U2A, and the second pin Uout of the NAND gate U2A is connected to the NAND gate U2B. The capacitor C7 is connected to the first pin Uin and grounded. The capacitor C8 is connected to a pin 14 of the NAND gate U2A and grounded. It can be understood that the oscillation frequency of the second trigger circuit 205 is the same as the oscillation frequency of the first trigger circuit 204, which will not be described again.

As shown in FIGS. 7 to 9, the second activation circuit 207 includes a resistor R6, a resistor R7, and a transistor Q4. The collector of the transistor Q4 is connected to the first pin Uin of the NAND gate U2A. Two ends of the resistor R7 are connected to the base and the emitter of the transistor Q4 respectively, and the emitter of the transistor Q4 is grounded. The resistor R6 is connected to the base of the transistor Q4 and the main control chip module 40 respectively.

As shown in FIG. 3 to FIG. 9, in exemplary embodiments, the second switch circuit 203 is the same as the first switch circuit 202. In exemplary embodiments, the second trigger circuit 205 is the same as the first trigger circuit 204. In exemplary embodiments, the second activation circuit 207 is the same as the first activation circuit 206. In exemplary embodiments of the present application, the second switch circuit 203 is different from the first switch circuit 202. In exemplary embodiments, the second trigger circuit 205 is different from the first trigger circuit 204. In exemplary embodiments, the second activation circuit 207 is different from the first activation circuit 206. The specific configuration may be set as needed and is not limited here.

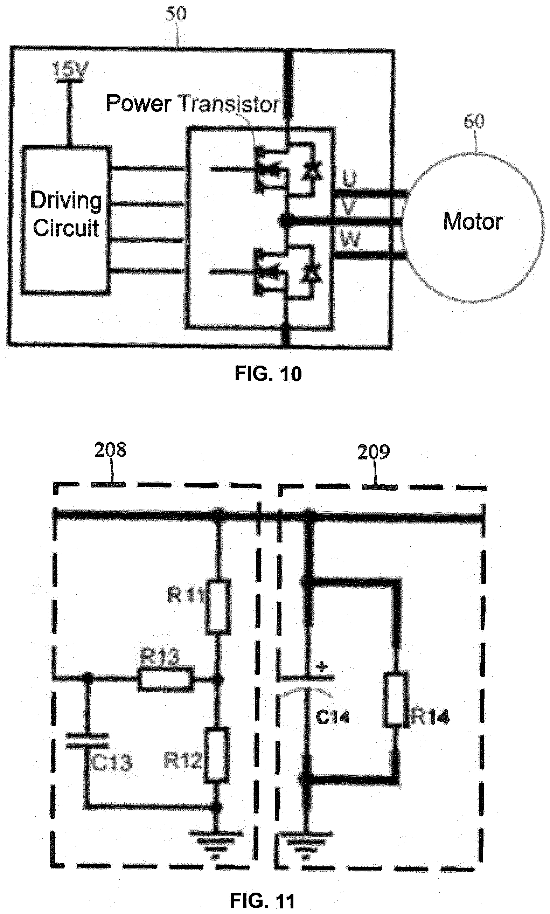

As shown in FIG. 11 and FIG. 12, the power supply control circuit further includes a voltage detection circuit 208 and a filtering circuit 209. The voltage detection circuit 208 is provided between the drive circuit module 50 and the battery pack. The voltage detection circuit 208 is connected to the main control chip module 40 and feeds back the detected voltage to the main control chip module 40. That is, the input end of the voltage detection circuit 208 is connected to the power supply path from the battery pack to the power tool, and the output end of the voltage detection circuit 208 is connected to the main control chip module 40, so that the main control chip module 40 can control the connection and disconnection of the battery pack through the control circuit based on the feedback of the voltage detection circuit 208. When the voltage detection circuit 208 detects that the voltage of a currently connected battery pack is less than a predetermined value, the main control chip module 40 controls the currently connected battery pack to be disconnected and selects another battery pack to be connected at the same time. The filtering circuit 209 is arranged between the voltage detection circuit 208 and the drive circuit module 50. That is, the voltage detection circuit 208 and the filtering circuit 209 are equivalent to being connected in series.

As shown in FIG. 11, in exemplary embodiments of the present application, the voltage detection circuit 208 includes a resistor R11, a resistor R12, a resistor R13, and a capacitor C13. In exemplary embodiments, the resistor R11 and the resistor R12 are connected in series, and one end of the resistor R11 is connected to the main circuit to which the first battery pack 101 and the second battery pack 102 are connected in parallel. That is, one end of the resistor R11 is connected on the side where the first electrical connection end B+ and the second electrical connection end B+ are connected in parallel. The other end of the resistor R12 is grounded. One end of the resistor R13 is connected between the resistor R11 and the resistor R12 and the other end of the resistor R13 is connected to the main control chip module 40. The capacitor C13 is connected in parallel to both ends of the resistor R13 and the resistor R12.

As shown in FIG. 11, the filtering circuit 209 includes a capacitor C14 and a resistor R14. In exemplary embodiments, the capacitor C14 is a polar capacitor, and the positive electrode of the capacitor C14 is connected to the main circuit to which the first battery pack 101 and the second battery pack 102 are connected in parallel. That is, the positive electrode of the capacitor C14 is connected on the side where the first electrical connection end B+ and the second electrical connection end B+ are connected in parallel, and the negative electrode of the capacitor C14 is grounded. The resistor R14 and the capacitor C14 are connected in parallel.

The working flow of the power supply control circuit of the present application will be described below with reference to FIG. 2 to FIG. 12.

In the default state, at first, the main control chip module 40 turns on the first battery pack 101, that is, the switching transistor Q2 and the switching transistor Q3 are turned on. Then the main control chip module 40 turns on the second battery pack 102, that is, the switching transistor Q5 and the switching transistor Q6 are turned on. In exemplary embodiments, in the case where the first battery pack 101 is not connected to the circuit but the second battery pack 102, the third battery pack, the fourth battery pack, etc., are connected to the circuit, the second battery pack 102 is prioritized in the order of working and controlling, and so on.

When the startup switch S1 is pressed, the power supply of the first battery pack 101 is started, which will be described below. The positive electrode of the first battery pack 101 provides a bias voltage through the diode D1, the diode D2, the startup switch S1, and the voltage stabilization diode ZD1, so that the switching transistor K2 and the switching transistor K1 are turned on to supply power to the voltage reduction circuit 23, and then the voltage reduction circuit 23 generates outputs of 15V and 5V, which respectively supply power to the drive circuit module 50, the main control chip module 40, etc., to make each circuit module enter the working mode.

Similarly, how the power supply of the second battery pack 102 is started will be described below. The positive electrode of the second battery pack 102 provides a bias voltage through the diode D4, the diode D3, the startup switch S1, and the voltage stabilization diode ZD1, so that the switching transistor K4 and the switching transistor K3 are turned on to supply power to the voltage reduction circuit 23, and then the voltage reduction circuit 23 generates outputs of 15V and 5V, which respectively supply power to the drive circuit module 50, the main control chip module 40, etc., to make each circuit module enter the working mode.

In exemplary embodiments of the present application, when the power tool is turned on, its working logic is described below. The main control chip module 40 first sends a high-level single pulse signal of about 1 ms to the resistor R1, the resistor R2, and the transistor Q1 of the first activation circuit 206, where the resistor R1 and the resistor R2 form a voltage dividing bias circuit of the transistor Q1. When the Ube of the transistor Q1 is greater than 0.7V, the transistor Q1 is turned on. At this time, pin 1 of the NAND gate U1A of the first trigger circuit 204 is pulled by the transistor Q1 to the ground, that is, 0 voltage. At this time, the output end Uout of pin 2 of the NAND gate U1A is 1, i.e., a high level, so the high level of pin 2 charges capacitor C1 through the resistor R3 in the feedback integration circuit. As the charging process proceeds, the voltage Uin of pin 1 gradually increases. When the voltage Uin of pin 1 rises to VT$^+$, the trigger circuit flips, and the output end Uout of pin 2 is 0, i.e., a low level. At this time, the capacitor C1 starts to discharge towards the resistor R3. When the voltage Uin of pin 1 drops to VT$^-$, the circuit flips again, and the output end Uout of pin 2 outputs a high level. After that, the capacitor C1 starts to charge again. In this way, the voltage Uin of pin 1 changes between VT$^+$ and VT$^-$ repeatedly, and the output end Uout continuously changes between high and low, thus forming self-oscillation (that is, a rectangular wave with a periodically changing oscillation frequency of f) repetitively. Changing the value of R3 or C1 can adjust the value of the output oscillation frequency f.

In the case where the oscillation pulse signal output by pin 2 of the NAND gate U1A passes through the NAND gate U1B and the NAND gate U1C connected in parallel and then flips again, the parallel connection point of pin 4 of the NAND gate U1B and pin 6 of the NAND gate U1C is set as point A, the point passing beyond the capacitor C3 is set as point B, and the connection of gates of the switching transistor Q2 and the switching transistor Q3 is set as point C. When point A becomes a high level for the first time, after being capacitively coupled by the capacitor C3, this coupled high level passes through the diode D5 and the resistor R4 in the first gate circuit to charge the capacitor C4 and the capacitor C5. As the voltage of the capacitor C5 gradually increases, once the voltage of the capacitor C5 rises to the gate threshold voltage VGS(th) of the switching transistor Q2, the switching transistor Q2 is turned on. Similarly, since the switching transistor Q3 and the switching transistor Q2 are connected in parallel, the switching transistor Q3 is also turned on at the same time. In this way, the positive voltage B+ of the first battery pack 101 is connected by the switching transistor Q2 and the switching transistor Q3 to provide power and electricity to the main circuit of the motor 60. Then the positive voltage B+ of the first battery pack 101 is fed back to point B through the diode D6, and then passes through the diode D5 and the resistor R4 to reach point C. At this time, the voltages of point B and point C are both raised to the voltage value of B+, which is the voltage value of the first battery pack 101.

In the case where the second high level arrives at point A, after being coupled by the capacitor C3, the coupled second high level is added onto the potential B+ at point B. This forms a bootstrap circuit. It is assumed that the voltage B+ of the positive electrode of the first battery pack 101 is 40V, at this time, the potential of point B is (B+)+15V, that is, 40V+15V=55V. Similarly, the potential of point C is the same as that of point B, that is, the potential of point C is also 55V. The voltages of the sources of the switching transistors Q2 and Q3 are B+, i.e., 40V, which meets the gate threshold voltage VGS(th) of the switching transistor Q2 and the switching transistor Q3 such that the switching transistor Q2 and the switching transistor Q3 are turned on again, and their switching frequency will operate according to the RC oscillation frequency f.

During the working process, the bus voltage is divided by two appropriate resistors, i.e., the resistor R11 and the resistor R12 in the voltage detection circuit 208. The divided voltage is connected to the AD pin of the main control chip module 40 for detection through a filtering circuit including the resistor R13 and the capacitor C13, and then the bus original voltage will be calculated.

When it is detected that the bus voltage is less than an undervoltage value and the duration exceeds the set time, undervoltage protection is started. That is, the main control chip module 40 detects whether the positive voltage B+ of the second battery pack 102 is less than N*2.8V, where N is the number of cells in the battery pack. When it is detected that the positive voltage B+ of the second battery pack 102 is less than N*2.8V for more than 2S, the first battery pack 101 takes a low-voltage protection action.

When the main control chip module 40 enters the low-voltage protection action, its shutdown logic is described below. The main control chip module 40 sends a high level to a pin of the resistor R1, causing the transistor Q1 in the first activation circuit 206 to conduct to be grounded. At this time, the voltage of pin 1 of the NAND gate U1A in the first trigger circuit 204 becomes 0, and pin 2 of the NAND gate U1A becomes high. After the NAND gate U1B and the NAND gate U1C flip again, that is, the voltage of point A becomes 0, no signal passes through the coupling capacitor C3. At this time, the voltage on the capacitor C4 is discharged by the resistor R4 and the resistor R5, and the voltage on the capacitor C5 is also discharged by the resistor R5. Finally, the voltage at point C is 0, causing the switching transistor Q2 and the switching transistor Q3 to be turned off at the same time, thereby cutting off the path for supplying power from the positive voltage B+ of the first battery pack 101 to the motor 60. Then, the discharge process of the first battery pack 101 is completed, and the first battery pack 101 takes the low-voltage protection action and switches to the next available battery pack, that is, automatically switches to the second battery pack 102. The working principle of the second battery pack 102 is the same as that of the first battery pack 101, which is described as follows.

At this time, the main control chip module 40 sends a second high-level single pulse signal of about 1 ms to the resistor R6, the resistor R7, and the transistor Q4 of the second activation circuit 207, where the resistor R6 and the resistor R7 form a voltage dividing bias circuit of the transistor Q4. When the Ube of the transistor Q4 is greater than 0.7V, the transistor Q4 is turned on. At this time, pin 1 of the NAND gate U2A of the second trigger circuit 205 is pulled by the transistor Q4 to the ground, that is, 0 level. At this time, the output end Uout of pin 2 of the NAND gate U2A is 1, i.e., a high level, so the high level of pin 2 of the NAND gate U2A charges the capacitor C7 through the resistor R8 in the feedback integration circuit. As the charging process proceeds, the voltage Uin of pin 1 of the NAND gate U2A gradually increases. When the voltage Uin of pin 1 of the NAND gate U2A rises to VT$^+$, the circuit of the second trigger circuit 205 flips, and the output end Uout of pin 2 of the NAND gate U2A is 0, i.e., a low level. At this time, the capacitor C7 begins to discharge toward the resistor R8. When the voltage Uin of pin 1 of the NAND gate U2A drops to VT-, the circuit flips again, and the output end Uout of pin 2 of the NAND gate U2A outputs a high level. After that, the capacitor C7 starts to charge again. In this way, the voltage Uin of pin 1 of the NAND gate U2A changes between VT$^+$ and VT$^-$ repeatedly, and the output end Uout continuously changes between high and low, thus forming self-oscillation (that is, a periodically changing rectangular wave) repetitively.

In the case where the oscillation pulse signal output by pin 2 of the NAND gate U2A passes through the NAND gate U2B and the NAND gate U2C connected in parallel and then flips again, the parallel connection of pin 4 of the NAND gate U2B and pin 6 of the NAND gate U2C is set as point D, the point passing beyond the capacitor C9 is set as point E, and the connection of gates of the switching transistors Q5 and Q6 is set as point F. When point D becomes a high level for the first time, after being capacitively coupled by the capacitor C9, this coupled high level passes through the diode D7 and the resistor R9 in the gate circuit to charge the capacitor C10 and the capacitor C11. As the voltage of the capacitor C11 gradually increases, once the voltage of the capacitor C11 rises to the gate threshold voltage VGS(th) of the switching transistor Q5, the switching transistor Q5 is turned on. Similarly, since the switching transistor Q6 and the switching transistor Q5 are connected in parallel, the switching transistor Q6 is also turned on at the same time. In this way, the positive voltage B+ of the second battery pack 102 is connected by the switching transistor Q5 and the switching transistor Q6, to provide power and electricity to the main circuit of the motor 60. Then the positive voltage B+ of the second battery pack 102 is fed back to point E through the diode D8, and then passes through the diode D7 and the resistor R9 to reach point F. At this time, the voltages of point E and point F are both raised to the voltage value of B+, which is the voltage value of the second battery pack 102.

In the case where the second high level arrives at point D, after being capacitively coupled by capacitor C9, the coupled second high level is added onto the potential B+ at point E. This forms a bootstrap circuit. It is assumed that the voltage B+ of the positive electrode of the second battery pack 102 is 40V, at this time, the potential of point E is (B+)+15V, that is, 40V+15V=55V. Similarly, the potential of point F is the same as that of point E, that is, the potential of point F is also 55V. The voltages of sources of the switching transistor Q5 and the switching transistor Q6 are B+, i.e., 40V, which meets the gate threshold voltage VGS(th) of the switching transistors Q5 and Q6 such that the switching transistors Q5 and Q6 are turned on again.

At this time, the bus voltage is divided by two appropriate resistors, i.e., the resistor R11 and the resistor R12 in the voltage detection circuit 208. The divided voltage is connected to the AD pin of the main control chip module 40 for detection through a filtering circuit including the resistor R13 and the capacitor C13, and then the bus original voltage will be calculated. When it is detected that the bus voltage is less than the undervoltage value and the duration exceeds the set time, undervoltage protection is started. That is, the main control chip module 40 detects whether the positive voltage B+ of the second battery pack 102 is less than N*2.8V, where N is the number of cells in the battery pack. When it is detected that the detection the positive voltage B+ of the second battery pack 102 is less than N*2.8V for more than 2S, the second battery pack 102 takes a low-voltage protection action and the main control chip module 40 enters an automatic switching mode.

The shutdown working logic is described below. At this time, the main control chip module 40 sends a high level to a pin of the resistor R6, causing the transistor Q4 in the second activation circuit 207 to conduct to be grounded. At this time, pin 1 of the NAND gate U2A in the second trigger circuit 205 becomes 0, and pin 2 of the NAND gate U2A becomes high. After the NAND gate U2B and the NAND gate U2C flip again, that is, the voltage of point D becomes 0, no signal passes through the coupling capacitor C9. At this time, the voltage of the capacitor C10 is discharged by the resistor R9 and the resistor R10, and the voltage on the capacitor C11 is also discharged by the resistor R10. Finally, the voltage at point F is 0, causing the switching transistors Q5 and Q6 to be turned off at the same time, thereby cutting off the path for supplying power from the positive voltage B+ of the second battery pack 102 to the motor 60. At this time, the discharge process of the second battery pack 102 is completed.

It should be noted that in the present application, the function of the switching transistor Q3 and the switching transistor Q6 in this circuit is described below. When the first battery pack 101 is working, the switching transistor Q2 and the switching transistor Q3 are turned on, and the positive electrode B+ of the first battery pack 101 supplies power to the main circuit of the motor 60. Since the internal flyback diode of the switching transistor Q6 is reversely connected to the circuit, the switching transistor Q6 is used to isolate the first battery pack 101 and the second battery pack 102 to prevent the reverse current from going from the first battery pack 101 to the second battery pack 102. When the second battery pack 102 is working, the switching transistors Q5 and Q6 are turned on, and the positive electrode B+ of the second battery pack 102 supplies power to the main circuit of the motor 60. Since the internal flyback diode of the switching transistor Q3 is reversely connected to the circuit, the switching transistor Q3 is used to isolate the second battery pack 102 and the first battery pack 101 to prevent reverse current from going to the first battery pack 101 from the second battery pack 102.

To sum up, in exemplary embodiments of the present application, at least two control circuits connected in parallel are provided between the drive circuit module and the battery pack, and the input end of the control circuit is connected to the main control chip module, and the output end of the control circuit is configured on the power supply path from the battery pack to the power tool. As a result, the main control chip module may control the connection and disconnection of the battery pack through the control circuit based on the feedback of the voltage detection circuit. When the voltage detection circuit detects that the voltage of the currently connected battery pack is less than the predetermined value, the main control chip module controls the currently connected battery pack to disconnect and select another battery pack to connect. Compared with the traditional technology, the present application may use the main control chip module to automatically switch the power supply from different battery packs, which is conducive to the miniaturization design of the PCB and reduces the overall cost.

The above embodiments are only used to illustrate the technical solutions of the present application and are not limiting. Although the present application has been described in detail with reference to the exemplary embodiments, those of ordinary skill in the art should understand that the technical solutions of the present application can be modified or equivalently substituted without departing from the scope defined by the appended claims.

## Claims

1. A power supply control circuit, comprising:

   a main control chip module (40) connected to at least two battery packs (101; 102);
   at least two control circuits connected in parallel with each other, wherein an input end of the control circuit is connected to the main control chip module (40), and an output end of the control circuit is provided on a power supply path from the battery pack (101; 102) to a power tool to control a connection and disconnection of the battery packs (101; 102), wherein the control circuit includes an activation circuit (206; 207), a trigger circuit (204; 205), and a switch circuit (202; 203) sequentially connected in series, and the activation circuit (206; 207) is connected to the main control chip module (40) such that the main control chip module (40) controls the activation circuit (206; 207) to be turned on to activate the trigger circuit (204; 205) to drive the switch circuit (202; 203) to control a connection state of the battery pack (101; 102), and
   a voltage detection circuit (208), an input end of the voltage detection circuit (208) is connected to the power supply path from the battery pack (101; 102) to the power tool, and an output end of the voltage detection circuit (208) is connected to the main control chip module (40), **characterized in that**
   the main control chip module (40) is configured to
   control the connection and disconnection of the battery packs (101; 102) through the control circuit based on feedback from the voltage detection circuit (208), and

   control a currently connected battery pack (101; 102) to be disconnected and select another battery pack (101; 102) to be connected when the voltage detection circuit (208) detects that a voltage of the currently connected battery pack (101; 102) is less than a predetermined value and the activation circuit (206; 207) includes two resistors (R1, R2; R6, R7) and one transistor (Q1; Q4),
   a base of the transistor (Q1; Q4) is connected to the main control chip module (40) through a first resistor (R1; R6) of the two resistors,
   an emitter of the transistor (Q1; Q4) is grounded, and
   a second resistor (R2; R7) of the two resistors is connected between the emitter and the base of the transistor (Q1; Q4) in series.

2. The power supply control circuit according to claim 1, wherein

   the trigger circuit (204; 205) is a flip-flop, and the flip-flop is configured to be activated by the activation circuit (206; 207) and generate a self-oscillation signal to drive the switch circuit (202; 203) to control the connection state of the battery pack (101; 102).

3. The power supply control circuit according to claim 2, wherein

   the flip-flop includes two capacitors (C1; C2), one resistor (R3), and three NAND gates (U1A; U1B; U1C),
   a first NAND gate (U1A) and a second NAND gate (U1B) of the three NAND gates are connected in parallel,
   the resistor (R3) is connected to a third NAND gate (U1C) of the three NAND gates in parallel,
   the third NAND gate (U1C) includes a first pin (Uin) and a second pin (Uout),
   the second pin (Uout) of the third NAND gate (U1C) is connected to the first NAND gate (U1A) and the second NAND gate (U1B),
   the two capacitors (C1; C2) are connected to the third NAND gate (U1C) and grounded.

4. The power supply control circuit according to claim 3, wherein an oscillation frequency of the flip-flop is:

$$f = \frac{1}{R3 \cdot C1 \cdot \ln\dfrac{VT^+(15 - VT^-)}{VT^-(15 - VT^+)}},$$

wherein $VT^+$ and $VT^-$ are a positive threshold voltage and a negative threshold voltage of the trigger circuit (204; 205) respectively, R3 is a resistance value of the resistor (R3) connected to the third NAND gate (U1C) in parallel, and C1 is a capacitance value of the capacitor (C1) connected to the first pin (Uin) and grounded.

5. The power supply control circuit according to claim 1, wherein

the switch circuit (202; 203) includes a gate circuit and a switching transistor (Q2; Q5) connected on the power supply path from the battery pack (101; 102) to the power tool in series, and
the connection state of the battery pack (101; 102) is controlled by turning-on and turning-off of the switching transistor.

6. The power supply control circuit according to claim 1, wherein

the switch circuit (202; 203) includes a gate circuit and two switching transistors (Q2, Q3; Q5, Q6) connected on the power supply path from the battery pack (101; 102) to the power tool in series,
the two switching transistors (Q2, Q3; Q5, Q6) are connected in parallel,
a first switching transistor (Q2; Q5) of the two switching transistors is connected to the battery pack (101; 102) in a forward direction, and
a second switching transistor (Q3; Q6) of the two switching transistors is connected to the battery pack (101; 102) in a reverse direction.

7. The power supply control circuit according to claim 1, further comprising a startup circuit (20) connected to the battery pack (101; 102) and the main control chip module (40),
wherein the startup circuit (20) supplies power to the main control chip module (40) and a drive circuit module (50) after the startup circuit (20) receives a triggering signal from the outside and a driving signal from the main control chip module (40).

8. The power supply control circuit according to claim 1, further comprising a filtering circuit (209), wherein

the filtering circuit (209) includes a capacitor (C14) and a resistor (R14) connected in parallel, and
a positive electrode of the capacitor (C14) is connected to a main circuit of the battery pack (101; 102).

9. A power tool provided with a power supply control circuit according to any one of claims 1 to 6, wherein the power supply control circuit further comprises:

a drive circuit module (50) connected to the main control chip module (40) and the battery pack (101; 102) respectively, wherein the drive circuit module (50) is also connected to a motor to drive the motor after the battery pack (101; 102) is connected.

10. A power tool system, comprising:

at least two battery packs (101; 102); and
a power tool according to claim 9.

**Patentansprüche**

1. Stromversorgungssteuerschaltung, umfassend:

ein Haupt-Steuerchipmodul (40), das mit mindestens zwei Batteriepacks (101; 102) verbunden ist;
mindestens zwei Steuerschaltungen, die miteinander parallel verbunden sind, wobei ein Eingangsende der Steuerschaltung mit dem Haupt-Steuerchipmodul (40) verbunden ist, und ein Ausgangsende der Steuerschaltung in einem Stromversorgungspfad von dem Batteriepack (101; 102) zu einem Elektrowerkzeug bereitgestellt ist, um eine Verbindung und Trennung der Batteriepacks (101; 102) zu steuern, wobei die Steuerschaltung eine Aktivierungsschaltung (206; 207), eine Auslöseschaltung (204; 205) und eine Schalterschaltung (202; 203) beinhaltet, die nacheinander in Reihe verbunden sind, und die Aktivierungsschaltung (206; 207) so mit dem Haupt-Steuerchipmodul (40) verbunden ist, dass das Haupt-Steuerchipmodul (40) die Aktivierungsschaltung (206; 207) so steuert, dass sie eingeschaltet wird, um die Auslöseschaltung (204; 205) zu aktivieren, um die Schalterschaltung (202; 203) anzusteuern, um einen Verbindungszustand des Batteriepacks (101; 102) zu steuern, und
eine Spannungserkennungsschaltung (208), wobei ein Eingangsende der Spannungserkennungsschaltung (208) mit dem Stromversorgungspfad von dem Batteriepack (101; 102) zu dem Elektrowerkzeug verbunden ist, und ein Ausgangsende der Spannungserkennungsschaltung (208) mit dem Haupt-Steuerchipmodul (40) verbunden ist, **dadurch gekennzeichnet, dass**
das Haupt-Steuerchipmodul (40) dazu konfiguriert ist,
die Verbindung und Trennung der Batteriepacks (101; 102) durch die Steuerschaltung auf Basis von Rückmeldung von der Spannungserkennungsschaltung (208) zu steuern, und
zu steuern, dass ein aktuell verbundenes Batteriepack (101; 102) getrennt wird, und ein anderes Batteriepack (101; 102) auszuwählen, das verbunden werden soll, wenn die Spannungserkennungsschaltung (208) erkennt, dass eine Spannung des aktuell verbundenen Batteriepacks (101; 102) kleiner ist als ein vorbestimmter Wert und die Aktivierungsschaltung (206; 207) zwei Widerstände (R1, R2; R6, R7) und einen Transistor (Q1; Q4) beinhaltet,

eine Basis des Transistors (Q1; Q4) durch einen ersten Widerstand (R1; R6) der zwei Widerstände mit dem Haupt-Steuerchipmodul (40) verbunden ist,

ein Emitter des Transistors (Q1; Q4) geerdet ist, und

ein zweiter Widerstand (R2; R7) der zwei Widerstände zwischen dem Emitter und der Basis des Transistors (Q1; Q4) in Reihe verbunden ist.

2. Stromversorgungssteuerschaltung nach Anspruch 1, wobei

die Auslöseschaltung (204; 205) ein Flip-Flop ist, und

das Flip-Flop so konfiguriert ist, dass es durch die Aktivierungsschaltung (206; 207) aktiviert wird und ein Eigenschwingungssignal erzeugt, um die Schalterschaltung (202; 203) anzusteuern, um den Verbindungszustand des Batteriepacks (101; 102) zu steuern.

3. Stromversorgungssteuerschaltung nach Anspruch 2, wobei

das Flip-Flop zwei Kondensatoren (C1; C2), einen Widerstand (R3) und drei NAND-Gatter (U1A; U1B; U1C) beinhaltet,

ein erstes NAND-Gatter (U1A) und ein zweites NAND-Gatter (U1B) der drei NAND-Gatter parallel verbunden sind,

der Widerstand (R3) mit einem dritten NAND-Gatter (U1C) der drei NAND-Gatter parallel verbunden ist,

das dritte NAND-Gatter (U1C) einen ersten Pin (Uin) und einen zweiten Pin (Uout) beinhaltet,

der zweite Pin (Uout) des dritten NAND-Gatters (U1C) mit dem ersten NAND-Gatter (U1A) und dem zweiten NAND-Gatter (U1B) verbunden ist,

die zwei Kondensatoren (C1; C2) mit dem dritten NAND-Gatter (U1C) verbunden und geerdet sind.

4. Stromversorgungssteuerschaltung nach Anspruch 3, wobei eine Schwingungsfrequenz des Flip-Flops lautet:

$$ f = \frac{1}{R3 \cdot C1 \cdot \ln \dfrac{VT^+(15 - VT^-)}{VT^-(15 - VT^+)}}, $$

wobei VT$^+$ und VT$^-$ eine positive Schwellenspannung bzw. eine negative Schwellenspannung der Auslöseschaltung (204; 205) sind, R3 ein Widerstandswert des Widerstands (R3) ist, der mit dem dritten NAND-Gatter (U1C) parallel verbunden ist, und C1 ein Kapazitätswert des Kondensators (C1) ist, der mit dem ersten Pin (Uin) verbunden und geerdet ist.

5. Stromversorgungssteuerschaltung nach Anspruch 1, wobei

die Schalterschaltung (202; 203) eine Gatterschaltung und einen Schalttransistor (Q2; Q5) beinhaltet, die in dem Stromversorgungspfad von dem Batteriepack (101; 102) zu dem Elektrowerkzeug in Reihe verbunden sind, und

der Verbindungszustand des Batteriepacks (101; 102) durch Einschalten und Ausschalten des Schalttransistors gesteuert wird.

6. Stromversorgungssteuerschaltung nach Anspruch 1, wobei

die Schalterschaltung (202; 203) eine Gatterschaltung und zwei Schalttransistoren (Q2, Q3; Q5, Q6) beinhaltet, die in dem Stromversorgungspfad von dem Batteriepack (101; 102) zu dem Elektrowerkzeug in Reihe verbunden sind,

die zwei Schalttransistoren (Q2, Q3; Q5, Q6) parallel verbunden sind,

ein erster Schalttransistor (Q2; Q5) der zwei Schalttransistoren in einer Durchlassrichtung mit dem Batteriepack (101; 102) verbunden ist, und

ein zweiter Schalttransistor (Q3; Q6) der zwei Schalttransistoren in einer Sperrrichtung mit dem Batteriepack (101; 102) verbunden ist.

7. Stromversorgungssteuerschaltung nach Anspruch 1, die weiter eine Anlaufschaltung (20) umfasst, die mit dem Batteriepack (101; 102) und dem Haupt-Steuerchipmodul (40) verbunden ist,

wobei die Anlaufschaltung (20) das Haupt-Steuerchipmodul (40) und ein Ansteuerschaltungsmodul (50) mit Strom versorgt, nachdem die Anlaufschaltung (20) ein Auslösesignal von außen und ein Ansteuersignal von dem Haupt-Steuerchipmodul (40) empfangen hat.

8. Stromversorgungssteuerschaltung nach Anspruch 1, die weiter eine Filterschaltung (209) umfasst, wobei

> die Filterschaltung (209) einen Kondensator (C14) und einen Widerstand (R14) beinhaltet, die parallel verbunden sind, und
> eine positive Elektrode des Kondensators (C14) mit einer Hauptschaltung des Batteriepacks (101; 102) verbunden ist.

9. Elektrowerkzeug, das mit einer Stromversorgungssteuerschaltung nach einem der Ansprüche 1 bis 6 versehen ist, wobei die Stromversorgungssteuerschaltung weiter umfasst:
ein Ansteuerschaltungsmodul (50), das mit dem Haupt-Steuerchipmodul (40) bzw. dem Batteriepack (101; 102) verbunden ist, wobei das Ansteuerschaltungsmodul (50) auch mit einem Motor verbunden ist, um den Motor anzusteuern, nachdem das Batteriepack (101; 102) verbunden wurde.

10. Elektrowerkzeugsystem, umfassend:

> mindestens zwei Batteriepacks (101; 102); und
> ein Elektrowerkzeug nach Anspruch 9.

**Revendications**

1. Circuit de commande d'alimentation électrique comprenant :

> un module de puce de commande principal (40) connecté à au moins deux blocs-batteries (101 ; 102) ;
> au moins deux circuits de commande connectés en parallèle l'un à l'autre, dans lequel une extrémité d'entrée du circuit de commande est connectée au module de puce de commande principal (40), et une extrémité de sortie du circuit de commande est fournie sur un chemin d'alimentation électrique du bloc-batterie (101 ; 102) à un outil électrique pour commander une connexion et une déconnexion des blocs-batteries (101 ; 102), dans lequel le circuit de commande inclut un circuit d'activation (206 ; 207), un circuit de déclenchement (204 ; 205) et un circuit de commutation (202 ; 203) connectés séquentiellement en série, et le circuit d'activation (206 ; 207) est connecté au module de puce de commande principal (40) de sorte que le module de puce de commande principal (40) commande la mise sous tension du circuit d'activation (206 ; 207) pour activer le circuit de déclenchement (204; 205) pour piloter le circuit de commutation (202 ; 203) pour commander un état de connexion du bloc-batterie (101 ; 102), et un circuit de détection de tension (208), une extrémité d'entrée du circuit de détection de tension (208) est connectée au chemin d'alimentation électrique du bloc-batterie (101 ; 102) à l'outil électrique, et une extrémité de sortie du circuit de détection de tension (208) est connectée au module de puce de commande principal (40), **caractérisé en ce que**
le module de puce de commande principal (40) est configuré pour
commander la connexion et la déconnexion des blocs-batteries (101 ; 102) par l'intermédiaire du circuit de commande sur la base du retour du circuit de détection de tension (208), et
commander la déconnexion d'un bloc-batterie (101 ; 102) actuellement connecté et sélectionner un autre bloc-batterie (101 ; 102) à connecter lorsque le circuit de détection de tension (208) détecte qu'une tension du bloc-batterie (101 ; 102) actuellement connecté est inférieure à une valeur prédéterminée et le circuit d'activation (206 ; 207) inclut deux résistances (R1, R2 ; R6, R7) et un transistor (Q1 ; Q4),
une base du transistor (Q1 ; Q4) est connectée au module de puce de commande principal (40) par l'intermédiaire d'une première résistance (R1 ; R6) des deux résistances,
un émetteur du transistor (Q1 ; Q4) est mis à la terre, et
une seconde résistance (R2 ; R7) des deux résistances est connectée en série entre l'émetteur et la base du transistor (Q1 ; Q4).

2. Circuit de commande d'alimentation électrique selon la revendication 1, dans lequel

> le circuit de déclenchement (204 ; 205) est une bascule, et
> la bascule est configurée pour être activée par le circuit d'activation (206 ; 207) et générer un signal d'auto-oscillation pour piloter le circuit de commutation (202 ; 203) pour commander l'état de connexion du bloc-batterie (101 ; 102).

3. Circuit de commande d'alimentation électrique selon la revendication 2, dans lequel

> la bascule inclut deux condensateurs (C1 ; C2), une résistance (R3) et trois portes NON-ET (U1A ; U1B ; U1C),
> une première porte NON-ET (U1A) et une deuxième porte NON-ET (U1B) des trois portes NON-ET sont connectées en parallèle,
> la résistance (R3) est connectée en parallèle à une troisième porte NON-ET (U1C) des trois portes NON-ET,
> la troisième porte NON-ET (U1C) inclut une première broche (Uin) et une seconde broche (Uout),

la seconde broche (Uout) de la troisième porte NON-ET (U1C) est connectée à la première porte NON-ET (U1A) et à la deuxième porte NON-ET (U1B),

les deux condensateurs (C1 ; C2) sont connectés à la troisième porte NON-ET (U1C) et mis à la terre.

4. Circuit de commande d'alimentation électrique selon la revendication 3, dans lequel la fréquence d'oscillation de la bascule est :

$$f = \cfrac{1}{R3 \cdot C1 \cdot \ln \cfrac{VT^+(15 - VT^-)}{VT^-(15 - VT^+)}},$$

dans lequel $VT^+$ et $VT^-$ sont respectivement une tension seuil positive et une tension seuil négative du circuit de déclenchement (204 ; 205), R3 est une valeur de résistance de la résistance (R3) connectée en parallèle à la troisième porte NON-ET (U1C) et C1 est une valeur de capacité du condensateur (C1) connecté à la première broche (Uin) et mis à la terre.

5. Circuit de commande d'alimentation électrique selon la revendication 1, dans lequel

le circuit de commutation (202 ; 203) inclut un circuit de porte et un transistor de commutation (Q2 ; Q5) connectés en série sur le chemin d'alimentation électrique du bloc-batterie (101 ; 102) à l'outil électrique, et

l'état de connexion du bloc-batterie (101 ; 102) est commandé par la mise sous tension et hors tension du transistor de commutation.

6. Circuit de commande d'alimentation électrique selon la revendication 1, dans lequel

le circuit de commutation (202 ; 203) inclut un circuit de porte et deux transistors de commutation (Q2, Q3 ; Q5, Q6) connectés en série sur le chemin d'alimentation électrique du bloc-batterie (101 ; 102) à l'outil électrique,

les deux transistors de commutation (Q2, Q3 ; Q5, Q6) sont connectés en parallèle,

un premier transistor de commutation (Q2 ; Q5) des deux transistors de commutation est connecté au bloc-batterie (101 ; 102) dans une direction avant, et

un second transistor de commutation (Q3 ; Q6) des deux transistors de commutation est connecté au bloc-batterie (101 ; 102) dans une direction arrière.

7. Circuit de commande d'alimentation électrique selon la revendication 1, comprenant en outre un circuit de démarrage (20) connecté au bloc-batterie (101 ; 102) et au module de puce de commande principal (40),

dans lequel le circuit de démarrage (20) alimente le module de puce de commande principal (40) et un module de circuit d'entraînement (50) après que le circuit de démarrage (20) reçoit un signal de déclenchement de l'extérieur et un signal d'entraînement du module de puce de commande principal (40).

8. Circuit de commande d'alimentation électrique selon la revendication 1, comprenant en outre un circuit de filtrage (209), dans lequel

le circuit de filtrage (209) inclut un condensateur (C14) et une résistance (R14) connectés en parallèle, et

une électrode positive du condensateur (C14) est connectée à un circuit principal du bloc-batterie (101 ; 102).

9. Outil électrique doté d'un circuit de commande d'alimentation selon l'une quelconque des revendications 1 à 6, dans lequel le circuit de commande d'alimentation comprend en outre :

un module de circuit d'entraînement (50) connecté respectivement au module de puce de commande principal (40) et au bloc-batterie (101 ; 102), dans lequel le module de circuit d'entraînement (50) est également connecté à un moteur pour entraîner le moteur après connexion du bloc-batterie (101 ; 102).

10. Système d'outil électrique, comprenant :

au moins deux blocs-batteries (101 ; 102) ; et
un outil électrique selon la revendication 9.

**FIG. 1**

EP 4 415 212 B1

**FIG. 2**

**FIG. 3**

**FIG. 4**

**FIG. 5**

**FIG. 6**

**FIG. 7**

FIG. 8

FIG. 9

FIG. 10

FIG. 11

**FIG. 12**

**REFERENCES CITED IN THE DESCRIPTION**

**Patent documents cited in the description**

- US 6268711 B

- US 2023238817 A